# EUROPÄISCHE PATENTSCHRIFT

(11) **EP 0 946 890 B1**
(45) Veröffentlichungstag und Bekanntmachung des Hinweises auf die Patenterteilung: **29.05.2002**
(21) Anmeldenummer: 97954706.4
(22) Anmeldetag: 20.12.1997
(51) Int. Cl.: G02B 5/20

(54) **SCHICHT MIT PORÖSEM SCHICHTBEREICH, EINE SOLCHE SCHICHT ENTHALTENDES INTERFERENZFILTER SOWIE VERFAHREN ZU IHRER HERSTELLUNG**
LAYER WITH A POROUS LAYER AREA, AN INTERFERENCE FILTER CONTAINING SUCH A LAYER AND A METHOD FOR THE PRODUCTION THEREOF
COUCHE A ZONE POREUSE, FILTRE INTERFERENTIEL RENFERMANT UNE TELLE COUCHE ET SON PROCEDE DE FABRICATION

(30) Priorität: 20.12.1996 DE 19653097
(43) Veröffentlichungstag der Anmeldung: 06.10.1999
(73) Patentinhaber: FORSCHUNGSZENTRUM JÜLICH GMBH, 52425 Jülich (DE)
(72) Erfinder: BERGER, Michael, D-53343 Wachtberg (DE); KRÜGER, Michael, D-52062 Aachen (DE); THÖNISSEN, Markus, D-41334 Nettetal (DE); ARENS-FISCHER, Rüdiger, D-52066 Aachen (DE); LÜTH, Hans, D-52074 Aachen (DE); LANG, Walter, D-78050 Villingen-Schwenningen (DE); THEISS, Wolfgang, D-72078 Aachen (DE); HILBRICH, Stefan, D-52134 Herzogenrath (DE)
(86) Internationale Anmeldenummer: DE9703006
(87) Internationale Veröffentlichungsnummer: WO9828781

(56) Entgegenhaltungen:
- DE-A- 4 319 413
- DE-A- 19 522 737
- DE-C- 4 410 657
- GB-A- 1 106 062
- US-A- 5 218 472

## Beschreibung

Die Erfindung betriff ein Interferenzfilter mit einer Schicht mit porösem Schichtbereich, gemäß dem Oberbegriff des Anspruchs 1. Desweiteren betrifft die Erfindung sein Verfahren zur Herstellung einer solchen Schicht, gemäß dem Oberbegriff des Anspruchs 2 oder 3.

Als Stand der Technik ist poröses Silicium (PS) bekannt, welches aufgrund seiner Kompatibilität zur hochentwickelten Si-Mikroelektronik sowie seiner einfachen und preiswerten Herstellbarkeit ein vielversprechendes Material für Anwendungen in der Sensorik (M. Thust et al., Meas. Sci. Technol., 6, (1995), sowie Y. Duvault-Herrera et al., Colloid. Surf., 50,197,(1990)) als auch aufgrund seiner Elektrolumineszenz für Anwendungen im Bereich der Displaytechnologie geeignet ist (P. Steiner et al., Appl. Phys. Lett., 62(21), 2700, (1993)). Weiterhin sind Anwendungen als farbsensitive Photodetektoren (M. Krüger et al., EMRS 96, Thin Solid films) oder passive Reflexionsfilter bekannt.

Die Herstellung von Schichtsystemen aus PS ist demonstriert worden (M.G. Berger et al., J. Phys. D: Appl. Phys., 27, 1333, (1994), DE P 43 19 413.3 oder M.G. Berger et al., Thin Solid Films, 255, 313, (1995)). Diese Schichtsysteme zeigen zum Beispiel als Schichtsysteme je nach Herstellungsparametern eine farbselektive Reflektivität. Weiterhin ist die strukturierte Herstellung von PS bekannt, so daß Bereiche mit unterschiedlichem spektralen Verhalten hergestellt werden können (M. Krüger et al., EMRS 95, Thin Solid films).

Im einzelnen besteht poröses Silicium aus einem schwammartigen Gerüst aus Silicium-Kristalliten, welches von Poren durchzogen ist. Die Größe der Kristallite und der Poren variiert je nach Dotierung und Herstellungsparametern zwischen einigen Nanometern und einigen Mikrometern. Falls die Wellenlänge des Lichtes sehr viel größer als die Strukturen im PS ist, erscheint das PS für das Licht als homogenes Material ("effektives Medium") und seine Eigenschaften können deshalb durch die Angabe eines effektiven Brechungsindexes beschrieben werden (W. Theiß: *The Use of Effective Medium Theories in Optical Spectroscopy,* in *Festkörperprobleme* / *Advances in Solid State Physics,* Band 33, Seite 149, Vieweg, Braunschweig/Wiesbaden), welcher von den Brechungsindizes der Silicumkristallite, eines evt. vorhandenen Oxids auf der Oberfläche der Kristallite und des Materiales in den Poren abhängt. Aus einzelnen zu einander paralle verlaufenden, porösen Schichten mit unterschiedlichen, optischen Eigenschaften können somit Interferenzfilter aufgebaut werden. Die verschiedenen Schichten sind dabei parallel zu einander aufgebaut und weisen innerhalb der jeweiligen Schicht eine senkrecht zur Schichtenoberfläche konstante Schichtdicke auf. Es ist jedoch nachteilig für unterschiedliche spektrale Charakteristiken jeweils ein separater Filter in separaten Arbeitsschritten herstellen zu müssen.

Nachteilig bei den bekannten Verfahren ist zudem, daß die Herstellung von benachbarten Filtern mit unterschiedlicher Charakteristik nur durch Photolithographieschritte bzw. durch separates Ätzen der Filter mit jeweils einer bestimmten Charakteristik erreicht werden kann.

Es ist deshalb Aufgabe der Erfindung ein Interferenzfilter mit einer einen porösen Schichtbereich enthaltende Schicht, sowie ein Verfahren zur Herstellung eines solchen bereitzustellen, bei dem eine vereinfachte Herstellung von Interferenzfilterfunktionen aus porösem Silicium mit lateral graduell veränderlicher Reflexions- und Transmissionscharakteristik erreicht wird.

Die Aufgabe wird gelöst durch ein Interferenzfilter gemäß der Gesamtheit der Merkmale nach Anspruch 1. Die Aufgabe wird weiter verfahrensmäßig gelöst durch ein Verfahren gemäß der Gesamtheit der Merkmale nach Anspruch 2 oder 3. Weitere zweckmäßige oder vorteilhafte Ausführungsformen oder Varianten finden sich in den auf jeweils einen dieser Ansprüche rückbezogenen Unteransprüchen.

Es wurde erkannt, basierend auf der bekannten Herstellung von Schichtsystemen auf porösem Silicium ein Verfahren bereitzustellen, bei dem eine laterale Änderung des Reflexions- und Transmissionsvermögens erreicht wird.

Im einzelnen wird dabei in einem einzigen Prozeßschritt ein Schichtsystem mit einer wohl definierten, lateral veränderlichen spektralen Charakteristik hergestellt. Dazu wird der poröse Schichtbereich gemäß Anspruch 1 so gebildet, daß innerhalb dieses Bereichs die Schichtdicke unterschiedliche Werte annimmt. Auf diese Weise erlaubt ein solch poröser Bereich je nach erwünschten Randbedingungen einstellbare Karakteristiken innerhalb dieser einzigen Schicht und bedarf es nicht mehr mehrere einzelne Komponenten, die, jeweils einzel hergestellt, mit unterschiedlicher Karakteristik sodann zusammengefügt werden müssen.

Zudem kann es vorteilhaft sein, innerhalb des porösen Bereichs mehrere verschiedene Porositätswerte vorzusehen, um individuell erwünschte Karakteristiken einstellbar auszubilden. Dazu kann auch der Porositätsgrad lateral, zum Beipiel kontinuierlich, ausgebildet sein. Der Bereich kann zudem mehrere Teilschichtbereiche aufweisen mit zueinander unterschiedlichem Porositätsgrad.

Es mag zur vereinfachten Herstellung zweckmäßig sein, die poröse Schicht und / oder die Teilschichtbereiche keilförmig auszubilden. Als Material kann vorzugsweise Al, GaAs oder SiGe vorgesehen sein, jedoch sehr vorteilhaft ist das in der Mikroelektronik vielfach verwendete Silizium.

Es wurde erkannt, zur Herstellung einer solchen Schicht verfahrensmäßig bei der Ätzung zur Porosidierung des Materials gemäß Anspruch 2 einen Gradienten aufzubauen bezüglich einer physikalischen Größe, die mit der Ätzgeschwindigkeit eines solchen Ätzvorgangs korreliert. Alternativ oder kummulativ kann gemäß Anspruch 3 eine Größe ausgewählt werden, die mit der Porosität des Materials korreliert. Als physikalische Größe kommen dazu vorteilhafterweise gemäß Anspruch 4 das elektrische Feld, gemäß Anspruch 7 die Temperatur, gemäß Anspruch 10 das Material des Substrats oder gemäß Anspruch 11 die Dotierung des Materials in Betracht, die sowohl einzeln oder auch in Kombinationen miteinander eingesetzt werden können.

Zur Bildung des Feldgradienten ist es gemäß Anspruch 4 vorteilhaft, die zur elektrochemischen Ätzung vorgesehene Elektroden einzusetzen. Dabei kann eine erste Elektrode in dem oberhalb der zu ätzenden Oberfläche befindlichen Elektrolyten angeordnet sein, während eine zweite Elektrode auf der dieser Oberfläche abgewandten Seite des Substrats aufgebracht ist. Zudem kann zur Bildung des Feldgradienten eine solche Elektrode verkippt angeordnet sein. Außerdem können gemäß Anspruch 6 die Elektroden netzförmig ausgebildet sein und zur Gradientenbildung Maschen aufweisen, die in Gradientenrichtung zunehmend verengt ausgebildet sind.

Das erfindungsgemäße Schichtsystem kann gemäß Ansprüche 7 und 8 durch Stromfluß, mit lateral gradueller Änderung der Reflexionsbzw. Transmissionscharakteristik unter Ausnutzung der Temperaturabhängigkeit des Ätzprozesses hergestellt werden. Diese Temperaturabhängigkeit des Ätzprozesses bewirkt, daß mit geänderter Temperatur des Elektrolyten/Substrates eine geänderte Ätzrate bzw. Porosität auftritt. Somit können Temperaturgradienten im Elektrolyten oder im Substrat lokal die Ätzrate und somit auch die optischen Eigenschaften eines Filters ändern.

Alternativ kann das erfindungsgemäße Schichtsystem mit lateral gradueller Änderung der Reflexions- bzw. Transmissionscharakteristik unter Ausnutzung einer geänderten Anoden- bzw. Kathodenanordnung während des Ätzens hergestellt sein. Die Abhängigkeit des Ätzprozesses von der Feldstärke zwischen Anode und Kathode bewirkt, daß mit geänderter Feldstärke zwischen den Elektroden eine geänderte Ätzrate bzw. Porosität auftritt. Somit können Feldstärkegradienten zwischen den Elektroden lokal die Ätzrate und somit auch die optischen Eigenschaften eines Filters ändern.

Jedoch ist die Erfindung nicht auf solche Verfahren beschränkt. Es sind weitere Alternativen des erfindungsgemäßen Verfahrens vorstellbar, bei dem eine die Ätzung beeinflussende Größe zur Einstellung einer graduellen Änderung der Porosität eingesetzt wird. Zum Beispiel kann auch die Dotierung des Substratmaterials vor der Ätzung so gewählt sein, daß sie einen lateralen Gradienten im Substrat aufweist.

Die Erfindung ist im weiteren an Hand von Figuren und Ausführungsbeispielen näher erläutert. Es zeigt:
Fig. 1: Erfindungsgemäße Schichtenfolge;
Fig. 2: Erfindungsgemäße Schichtenfolge;
Fig. 3: Erfindungsgemäße Schichtenfolge;
Fig. 4: Erfindungsgemäße Struktur.

### Ausführungsbeispiele

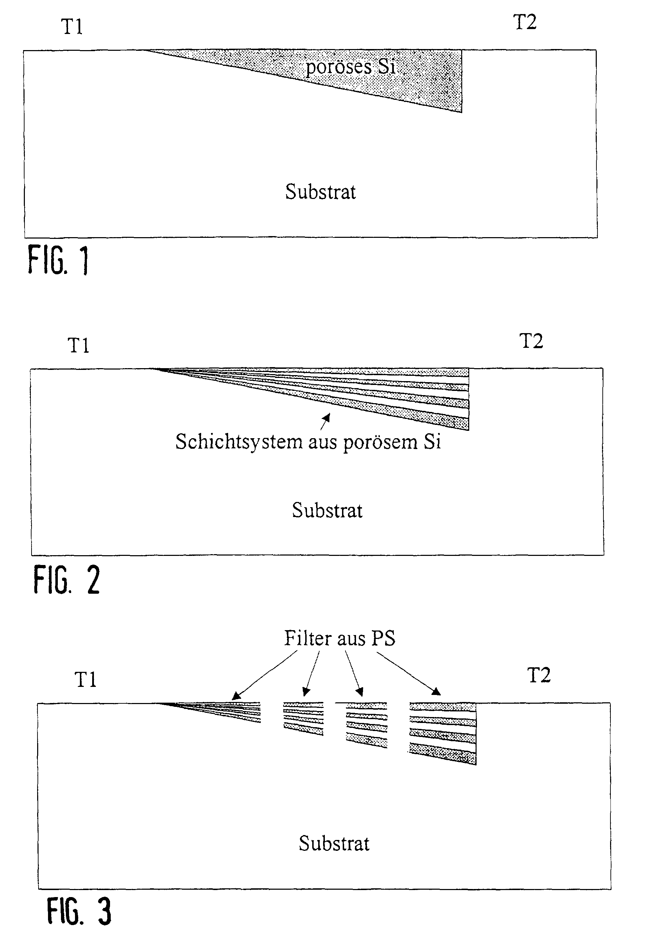

In der Figur 1 ist der erfindungsgemäße Querschnitt eines auf einem Wafer gebildeten Interferenzfilters, auf dem poröses Silicium geätzt wurde, dargestellt. Aufgrund der unterschiedlichen Temperaturen T1 und T2 und der damit verbundenen Änderung der Ätzraten bildete sich eine keilförmige Struktur aus.

In der Figur 2 ist ebenfalls der Querschnitt eines erfindungsgemäßen Filters gezeigt, welches jedoch als Schichtsystem mit unterschiedlich porösen Bereichen aufgebaut ist. Aufgrund der unterschiedlichen Dicken der Einzelschichten wird eine laterale, graduelle Änderung der Interferenzcharakteristik erzielt.

Schließlich ist in Figur 3 analog zu den vorangegangenen Figuren ein lateral graduelles Schichtsystem dargestellt mit einzelnen in einem einzigen Verfahrensschritt hergestellten Pixeln.

Insbesondere bezüglich der in den Patentansprüchen 4-6 und 11 beschriebenen Erfindung wird noch folgendes ausgeführt:

Im Rahmen der Zielsetzung der Erfindung, lateral inhomogene Schichten oder Filter herzustellen, insbesondere mit lateral geänderter Reflexionscharakteristik, wurde erkannt, daß die gezielte Anordnung oder Ausbildung bzw. Änderung des rückseitigen Kontakts die Struktur des erfindungsgemäßen Gegenstandes, insbesondere des Filters, erheblich vorteilhaft beeinflußt.

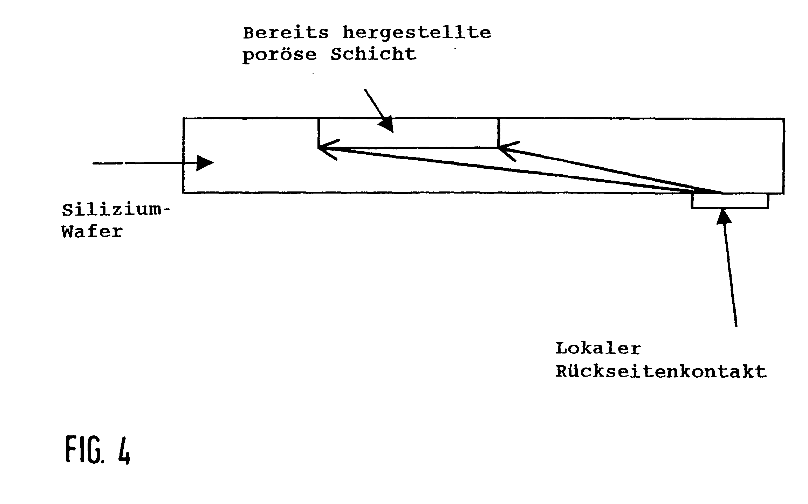

In der in der Figur 4 dargestellten erfindungsgemäßen Struktur ist der Stromfluß vom lokalen Rückseitenkontakt zu der porösen Schicht unterschiedlich, da die Ladungsträger unterschiedlich lange Wege vom Kontaktpunkt zur porösen Schicht zurücklegen müssen. Dieses Verhalten ist einerseits von der Größe der porösen Struktur, andererseits vom Abstand des Rückseitenkontaktes zur porösen Schicht und damit schließlich vom Substratwiderstand abhängig. Die Ätzrate ist auf diese Weise an den verschiedenen Stellen der Struktur unterschiedlich, was im Ergebnis zur Ausbildung von Interferenzfiltern mit lateral graduell veränderlicher Charakteristik führt.

Auf diese Weise kann bezüglich der in den Patentansprüchen beanspruchten Gegenstände, speziell was die Änderung des elektrischen Feldes betrifft, eine breite Anwendung darin gelegenen sein, die Verlaufsgeometrie der Reflexionscharakteristik auf der erfindungsgemäßen Struktur lateral geeignet auszubilden. Beispielsweise kann als Kontaktgeometrie des rückseitigen Kontaktes eine Mehrzahl von einzelnen lokalen Kontakten an unterschiedlichen Stellen auf der Rückseite vorgesehen sein. Darüber hinaus ist es vorstellbar, diese lokalen Kontakte mit unterschiedlichen Strömen beaufschlagbar auszubilden, wie in Anspruch 13 beansprucht.

## Patentansprüche

1. Interferenzfilter mit einer Schicht, die einen porösen Bereich aufweist, der sich von der Oberfläche der Schicht in das Innere dieser Schicht erstreckt,
**dadurch gekennzeichnet,**
**daß** der Interferenzfilter eine oder mehrere Schichten nach dem Oberbegriff aufweist und die Abmessungen des porösen Bereiches in der zur Schichtoberfläche senkrechten Richtung unterschiedliche Werte aufweisen.

2. Verfahren zur Herstellung einer Schicht mit einem porösen Schichtbereich oder Schichtsystem durch Atzung mit den Schritten
- eine physikalische Größe wird gewählt, die während der Ätzung mit der Ätzgeschwindigkeit in der Schicht korreliert;
- die Ätzung der Schicht wird in Abhängigkeit von dieser physikalischen Größe durchgeführt;
- während der Ätzung wird ein geeigneter Gradient der physikalischen Größe derart eingestellt, daß sich entsprechend der unterschiedlichen Ätzgeschwindigkeiten der poröse Bereich mit unterschiedlichen Abmessungen ausbildet.

3. Verfahren zur Herstellung einer Schicht mit einem porösen Schichtbereich oder Schichtsystem durch Ätzung mit den Schritten
- eine physikalische Größe wird gewählt, die während der Ätzung mit der Porosität in der Schicht korreliert;
- die Ätzung der Schicht wird in Abhängigkeit von dieser physikalischen Größe durchgeführt;
- während der Ätzung wird ein geeigneter Gradient der physikalischen Größe derart eingestellt, daß sich der poröse Bereich mit unterschiedlichen Porositäten ausbildet.

4. Verfahren zur Herstellung einer Schicht nach Anspruch 2 oder 3, wobei als Mittel zum elektrochemischen Ätzen vorgesehene Elektroden zur Ausbildung eines Feldstärkeunterschieds oder -gradienten über der zu ätzenden Fläche eingesetzt werden.

5. Verfahren nach vorhergehendem Anspruch 4, wobei zur Bildung des Feldstärkeunterschieds oder -gradienten über der zu ätzenden Fläche die dem zu ätzenden Substratoberflächenbereich gegenüberliegende Elektrode verkippt angeordnet wird.

6. Verfahren nach Anspruch 4 oder 5, wobei zur Bildung des Feldstärkeunterschieds oder -gradienten über der zu ätzenden Fläche eine netzförmige Elektrode gewählt wird und die in dieser netzförmigen Elektrode enthaltenen Maschen in Richtung des erwünschten Gradienten verengt ausgebildet werden.

7. Verfahren nach Anspruch 2 oder 3, bei dem das Substrat oder der zur Ätzung vorgesehene Elektrolyt einem von außen gesteuerten Temperaturgradienten oder Temperaturunterschied über der zu ätzenden Fläche ausgesetzt wird.

8. Verfahren nach einem der vorhergehenden Ansprüche, bei dem durch Stromfluß durch das Substrat dieses lokal unterschiedlich erwärmt wird.

9. Verfahren nach einem der vorhergehenden Ansprüche, bei dem durch lokale Erwärmung des Substrates, ins besondere mittels Laser oder Mikrowellen, ein Temperaturgradient im Substrat oder Elektrolyten hervorgerufen wird.

10. Verfahren nach Anspruch 2 oder 3, bei dem modifiziertes Substratmaterial gewählt wird.

11. Verfahren nach Anspruch 2 oder 3, bei dem als physikalische Größe die Dotierung des Substrats gewählt wird.

12. Verfahren nach einem der vorhergehenden Ansprüche, bei dem ein oder mehrere durch Photolithographie strukturierte Bereiche lokal oder global dem Gradienten der physikalischen Größe ausgesetzt werden.

13. Interferenzfilter gemäß Anspruch 1, oder nach einem Verfahren gemäß Anspruch 2 bis 12 hergestellte Schicht mit einer lateral geeignet ausgebildeten Geometrie eines elektrischen, rückseitigen Kontaktes, insbesondere mit einer Mehrzahl von einzelnen lokalen Kontakten an unterschiedlichen Stellen auf der Rückseite, wobei diese Kontakte gegebenenfalls mit unterschiedlichen Strömen beaufschlagbar sind.

## Claims

1. Interference filter with a layer having a porous area extending from the surface of the layer into the interior of this layer, **characterised in that** the interference filter comprises one or more layers according to the concept, and the dimensions of the porous area have different values in the direction perpendicularly to the layer surface.

2. Method for production of a layer with a porous layer area or layer system by etching, including the following steps:
- a physical size is selected which during etching correlates with the etching speed in the layer;
- etching of the layer is carried out in dependence of this physical size;
- a suitable gradient of the physical size is set during etching in such a manner that, corresponding with the different etching speeds, the porous area develops with different dimensions.

3. Method for production of a layer with a porous layer area or layer system by etching, including the following steps:
- a physical size is selected which during etching correlates with the porosity in the layer;
- etching of the layer is carried out in dependence of this physical size;
- a suitable gradient of the physical size is set during etching in such a manner that the porous area develops with different porosities.

4. Method for production of a layer according to Claim 2 or 3, and electrodes provided as means of electro-chemical etching are used to develop a field strength difference of field strength gradient over the surface to be etched.

5. Method according to above Claim 4, and the electrode positioned opposite the substrate surface area to be etched is tilted so as to form the field strength difference or field strength gradient over the surface to be etched.

6. Method according to Claim 4 or 5, and a netshaped electrode is chosen for forming the field strength difference or field strength gradient over the surface to be etched, and the mesh contained in this netshaped electrode is designed to be narrowing in the direction of the desired gradient.

7. Method according to Claim 2 or 3, and the substrate or the electrolyte provided for etching is subjected to an externally controlled temperature gradient or temperature difference above the surface to be etched.

8. Method according to one of the above claims, and the substrate is locally differently heated by a current flow through the substrate.

9. Method according to one of the above claims, and a temperature gradient is produced in the substrate or electrolyte by way of local heating of the substrate, in particular by means of laser or microwaves.

10. Method according to Claim 2 or 3, and a modified substrate material is selected.

11. Method according to Claim 2 or 3, and doping of the substrate is selected as physical size.

12. Method according to one of the above claims, and one or more areas structured by photo-lithography are locally or globally subjected to the gradient of the physical size.

13. Interference filter according to Claim 1 or a layer produced by a method according to Claim 2 to 12 with a suitably designed lateral geometry of an electrical rearsided contact, in particular with a plurality of individual local contacts at different points at the rear, and to these contacts can be applied different currents, if appropriate.

## Revendications

1. Filtre interférentiel avec une couche présentant une zone poreuse, qui s'étend de la surface de la couche à l'intérieur de cette couche,
**caractérisé en ce que** le filtre interférentiel présente une ou plusieurs couches définies selon le préambule et les dimensions de la zone poreuse présentent des valeurs différentes dans la direction perpendiculaire à la surface de la couche.

2. Procédé pour fabriquer une couche avec une zone poreuse ou un système de couche par décapage avec les étapes suivantes
- on choisit une grandeur physique qui est en corrélation pendant le décapage avec la vitesse de décapage dans la couche ;
- le décapage de la couche est effectué en fonction de cette grandeur physique ;
- pendant le décapage, on ajuste un gradient approprié de grandeur physique de telle façon que la zone poreuse avec des dimensions différentes se forme en fonction des vitesses de décapage différentes.

3. Procéder pour fabriquer une couche avec une zone poreuse ou un système de couche par décapage avec les étapes suivantes
- on choisit une grandeur physique qui est en corrélation pendant le décapage avec la porosité dans la couche ;
- le décapage de la couche est effectué en fonction de cette grandeur physique ;
- pendant le décapage, on ajuste un gradient approprié de grandeur physique de telle façon que la zone poreuse se forme avec des porosités différentes.

4. Procédé pour fabriquer une couche selon la revendication 2 ou 3, des électrodes prévues comme moyen pour le décapage électrochimique étant utilisées pour obtenir une différence ou un gradient d'intensité de champ sur la surface à décaper.

5. Procédé selon la revendication 4 précédente, l'électrode opposée à la zone superficielle du substrat à décaper étant disposée de façon basculée pour former la différence ou le gradient d'intensité de champ sur la surface à décaper.

6. Procédé selon la revendication 4 ou 5, une électrode en forme de filet étant choisie pour former la différence ou le gradient d'intensité de champ sur la surface à décaper et les mailles incluses dans cette électrode en forme de filet étant conçues avec un rétrécissement dans le sens du gradient souhaité.

7. Procédé selon la revendication 2 ou 3, avec lequel le substrat ou l'électrolyte prévu pour le décapage est exposé à un gradient de température ou une différence de température contrôlé(e) par l'extérieur sur la surface à décaper.

8. Procédé selon l'une quelconque des revendications précédentes, avec lequel le substrat est réchauffé localement de façon différente par le flux de courant traversant le substrat.

9. Procédé selon l'une quelconque des revendications précédentes, avec lequel un gradient de température dans le substrat ou l'électrolyte est provoqué par réchauffement local du substrat, en particulier par laser ou micro-ondes.

10. Procédé selon la revendication 2 ou 3, avec lequel on choisit un matériau de substrat modifié.

11. Procédé selon la revendication 2 ou 3, avec lequel on choisit le dopage du substrat comme grandeur physique.

12. Procédé selon l'une quelconque des revendications précédentes, avec lequel une ou plusieurs zones structurées par photolithographie est ou sont exposée(s) localement ou globalement au gradient de la grandeur physique.

13. Filtre interférentiel selon la revendication 1 ou couche fabriquée selon un procédé défini selon les revendications 2 à 12 avec une géométrie, une conception appropriée au plan latéral, d'un contact électrique côté arrière, en particulier avec une grande quantité de contacts locaux individuels placés en différents endroits sur l'arrière, ces contacts pouvant être sollicités le cas échéant avec différents courants.
